Europäisches Patentamt

European Patent Office

Office européen des brevets

(19)

(11) Veröffentlichungsnummer: **0 282 748 B1**

(12) # EUROPÄISCHE PATENTSCHRIFT

(45) Veröffentlichungstag der Patentschrift:
13.03.91 Patentblatt 91/11

(51) Int. Cl.⁵: **B05C 5/02, B05C 11/10,**
**H05K 13/04**

(21) Anmeldenummer: 88102311.3

(22) Anmeldetag: 17.02.88

(54) **Vorrichtung zur dosierbaren Klebstoff-Applikation.**

(30) Priorität: 16.03.87 DE 3708530

(43) Veröffentlichungstag der Anmeldung:
21.09.88 Patentblatt 88/38

(45) Bekanntmachung des Hinweises auf die
Patenterteilung:
13.03.91 Patentblatt 91/11

(84) Benannte Vertragsstaaten:
CH DE FR GB IT LI

(56) Entgegenhaltungen:
DE-A- 2 157 854
DE-A- 2 414 895

(56) Entgegenhaltungen:
DE-A- 2 819 440
DE-A- 3 346 254
DE-A- 3 537 125
US-A- 3 775 058
US-A- 4 515 297
US-A- 4 598 842

(73) Patentinhaber: Siemens Aktiengesellschaft
Wittelsbacherplatz 2
W-8000 München 2 (DE)

(72) Erfinder: Martin, Bernhard, Dipl.-Ing.
Hauptstrasse 34
W-8031 Wessling (DE)
Erfinder: Wacker, Josef, Dipl.-Ing.
Kirchanger 1
W-8137 Höhenrain (DE)

EP 0 282 748 B1

## Beschreibung

Die Erfindung betrifft eine Vorrichtung zur dosierbaren Klebstoff-Applikation auf ein Substrat, insbesondere für SMD-Bestückautomaten.

Bei der automatischen Bestückung von Leiterplatten mit SMD-Bausteinen für die Oberflächen-Montage (SMD = Surface Mounted Devices) werden durch eine in einer Positioniereinheit angeordnete Dosiervorrichtung zunächst Klebstoff-Tropfen aufgebracht, auf welche die SMD-Bausteine dann aufgesetzt werden. Der Klebstoff härtet dann durch die Einwirkung von Temperatur oder UV-Strahlung aus. Die SMD-Bausteine sind danach in der richtigen Lage so fest auf der Leiterplatte fixiert, daß die elektrische Verbindung im Schwallbad, durch Reflow-Löten oder durch Löten in der Dampf-Phase hergestellt werden kann. Die für die Klebstoff-Applikation eingesetzten Dosiervorrichtungen bestehen im wesentlichen aus einer in einer federnden Halterung angeordneten und mit Druckluft beaufschlagbaren Klebstoff-Kartusche, einer in die Klebstoff-Kartusche eingesetzten Dosiernadel und einem der Dosiernadel zugeordneten Abstandshalter. Zum Aufbringen eines Klebstoff-Tropfens wird diese in der Positioniereinheit des SMD-Bestückautomaten angeordnete Dosiervorrichtung abgesenkt, bis der Abstandshalter auf der Leiterplatte aufsitzt, wobei der dadurch verursachte Stoß durch ein Einfedern der Klebstoff-Kartusche aufgefangen wird. Aus der sich in dieser abgesenkten Stellung knapp oberhalb der Leiterplatte befindlichen Dosiernadel wird dann durch Druckluftbeaufschlagung der Klebstoff-Kartusche ein Klebstoff-Tropfen auf die Leiterplatte gepreßt, wobei die aufdosierte Klebstoffmenge von der Dosierzeit, vom Druck mit dem die Klebstoff-Kartusche beaufschlagt wird, von der Nadelgeometrie und der Viskosität des Klebstoffes abhängt. Die dynamische Viskosität hängt ihrerseits von der Temperatur des Klebstoffes ab.

In der älteren, nicht vorveröffentlichten europäischen Patentanmeldung gemäß der EP-A-0 219 177 ist eine Vorrichtung zur dosierbaren Klebstoff-Applikation auf ein Substrat beschrieben, welche insbesondere für Klebearbeiten auf dem Gebiet elektronischer Bauteile (LCD,SMD) eingesetzt wird. Diese Vorrichtung umfaßt einen länglichen, rohrförmigen Kleberaum, der durch einen piezoelektrischen Wandler mit Druckimpulsen beaufschlagbar ist und dessen Ende zur Formung einer Abgabedüse verjüngt ist. Zwischen dem piezoelektrischen Wandler und der Abgabedüse ist eine den rohrförmigen Kleberaum umgebende Heizeinrichtung vorgesehen. Diese durch eine Heizspirale gebildete Heizeinrichtung hat die Aufgabe, den Klebstoff im Kleberaum zur Reduzierung seiner Viskosität zu erwärmen.

Aus der US-A-4 515 297 ist eine Vorrichtung zur Klebstoff-Applikation auf ein Substrat bekannt, bei welcher eine mit Druckluft beaufschlagbare Klebstoff-Kartusche eine mit einer Vielzahl von Austrittsöffnungen versehene Düsenplatte trägt. Einer die Klebstoff-Kartusche ringförmig umgebenden Kammer kann zur Kontrolle der Viskosität des Klebstoffes und damit zur Erhöhung der Dosiergenauigkeit warme Luft zugeführt werden.

Der Erfindung liegt die Aufgabe zugrunde, eine Vorrichtung zur dosierbaren Klebstoff-Applikation auf ein Substrat zu schaffen, bei welcher mit geringem Aufwand die Dosiergenauigkeit weiter erhöht werden kann.

Diese Aufgabe wird erfindungsgemäß durch die im Anspruch 1 angegebenen Merkmale gelöst.

Temperaturschwankungen haben einen sehr großen Einfluß auf das Verhalten des Klebstoffes beim Dosieren. Erwärmung oder Abkühlung, z.B. Änderung der Umgebungstemperatur oder Erhöhung der Klebstofftemperatur durch die Luftkompression in der Kartusche bewirken erhebliche Viskositätsänderungen des Klebstoffes. Messungen an handelsüblichen Klebstoffen für die SMD-Technik haben ergeben, daß eine Temperaturerhöhung um 5°C eine Verdoppelung der Voluminia der applizierten Klebstoff-Tropfen bewirkt. Andererseits ist der Aufwand für die bekannte Temperaturstabilisierung des Klebstoffes in der Kartusche viel zu groß, da hierzu eine effektive Kühl- und/oder Heizleistung von ca. 7 Watt benötigt wird. Mit der erfindungs gemäßen vorrichtung zur dosierbaren klebstoff-Applikation Kann eine Temperaturstabilisierung des durch die Dosiernadel hindurchgeführten Klebstoffes mit einer Kühl- und-/oder Heizeinrichtung geringer Leistung bewirkt werden. Insbesondere ergibt sich bei einer Temperaturbeeinflussung im Bereich der Dosiernadel auf Grund der geringen Durchflußgeschwindigkeiten eine äußerst günstiges Verhältnis des Klebstoffvolumenstroms zur Oberfläche. Diese Temperaturstabilisierung des durch die Dosiernadel hindurchgeführten Klebstoffes wird durch eine die Dosiernadel zumindest bereichsweise umgebende Kammer ermöglicht, welcher ein Kühl- und/oder Heizmittel zuführbar ist. Durch eine derartige indirekte Kühlung und/oder Heizung mit einem vorzugsweisen gasförmigen Kühl- und/oder Heizmittel kann im Hinblick auf den Platzmangel im Bereich der Dosiernadel eine besonders effektive Temperaturstabilisierung erzielt werden.

Mündet dann in den unteren Bereich der Kammer ein Röhrchen für die Zufuhr des Kühl- und/oder Heizmittels ein, so kann auf besonders einfache Weise das für die Temperaturstabilisierung des Klebstoffes günstige Gegenstromprinzip realisiert werden. Außerdem kann dann an das im Hinblick auf die Wärmeleitfähigkeit vorzugsweise aus Metall bestehende Röhrchen ein Temperatur-Meßfühler angebracht werden, der eine genaue Regelung und Konstanthaltung der Temperatur des durch die Dosiernadel hindurchgeführten Klebstoffes ermöglicht. Das Röhrchen ermöglicht den lösbaren Anschuß eines Schlauches für die Zufuhr des Kühl-und/oder Heizmittels. Außerdem ergibt sich ein guter Wärmekontakt zur Dosiernadel.

Es hat sich auch als vorteilhaft erwiesen, wenn an der Kammer ein nach unten ragender Abstandshalter angebracht ist. Durch eine derartige Integration des Abstandshalters ergibt sich eine weitere Verringerung des baulichen Aufwands.

Gemäß einer besonders bevorzugten Ausgestaltung der Erfindung ist zur Temperaturbeeinflussung des Kühl- und/oder Heizmittels ein Peltier-Element vorgesehen. Ein derartiges mit Halbleitermaterialien gebautes Thermoelement kann dann sowohl zur thermoelektrischen Kühlung als auch zur thermoelektrischen Heizung verwendet werden. Die Absorption oder Entwicklung der sogenannten Peltierwärme, die durch eine einfache Umkehr der Stromrichtung gesteuert werden kann, ermöglicht dann eine äußerst flexible Temperaturstabilisierung auf einem unter, über oder bei Raumtemperatur liegenden Temperaturniveau.

Ein besonders geringer Aufwand bei effektiver Kühlung oder Heizung ergibt sich dann, wenn das Kühl- und/oder Heizmittel vor dem Eintritt in die Kammer durch einen mit dem Peltier-Element verbundenen Wärmetauscher hindurchführbar ist. In diesem Fall ist es dann auch zweckmäßig, wenn dem Peltier-Element ein zweiter Wärmetauscher für die Abgabe oder Zufuhr von Wärme an oder aus der Umgebung zugeordnet ist.

Im folgenden wird ein Ausführungsbeispiel der Erfindung anhand der Zeichnung näher erläutert.

Es zeigen

Fig. 1 einen teilweisen Längsschnitt durch eine Dosiervorrichtung für das berührungslose Aufbringen von Klebstoff-Tropfen auf eine Leiterplatte und

Fig. 2 den temperaturstabilisierten Dosiernadelbereich der Dosiervorrichtung gemäß Fig. 1 im Detail.

Die Zeichnung zeigt in stark vereinfachter schematischer Darstellung eine Dosiervorrichtung Dv zum Aufbringen von Klebstoff-Tropfen KT auf eine Leiterplatte Lp. Auf diese Leiterplatte Lp werden dann anschließend SMD-Bausteine aufgebracht und bis zum Löten durch die Klebstoff-Tropfen KT fixiert. Die gesamte Dosiervorrichtung Dv wird hierbei in einem programmgesteuerten SMD-Bestückautomaten eingesetzt, welcher für die Simultanbearbeitung positionsgleicher Arbeitsgänge ausgelegt ist. Auf diese Weise können dann auf eine Leiterplatte Lp Klebstoff-Tropfen KT für einen bestimmten SMD-Baustein aufgebracht werden, während simultan dazu auf eine andere, bereits mit Klebstoff-Tropfen KT versehene Leiterplatte Lp der entsprechende SMD-Baustein aufgesetzt wird.

Die gesamte Dosiervorrichtung Dv ist über eine Halterung H in einer nicht näher dargestellten Positioniereinheit des SMD-Bestückautomaten angeordnet. In der Dosiervorrichtung Dv ist eine mit hochviskosem Klebstoff gefüllte Klebstoff-Kartusche KK angeordnet, deren unteres Ende eine als Hohlnadel ausgebildete Dosiernadel Dn trägt. Die als Einweg-Kartusche eingesetzte Klebstoff-Kartusche KK kann durch das Lösen eines federnden Klemmbügels Kb leicht ausgewechselt werden. Von oben her mündet in die Dosiervorrichtung Dv ein flexibler Schlauch Scl ein, über welchen die Klebstoff-Kartusche KK mit Druckluft Dl beaufschlagt werden kann. Zum Aufbringen der Klebstoff-Tropfen KT auf die Leiterplatte Lp wird die gesamte Dosiervorrichtung Dv durch die Positoniereinheit abgesenkt, bis ein mit Ah bezeichneter Abstandshalter auf der Leiterplatte Lp aufsitzt, wobei der dadurch verursachte Stoß durch Einfedern der Dosiervorrichtung Dv mittels einer, Druckfeder Df aufgefangen wird. Aus der sich in dieser abgesenkten Stellung knapp oberhalb der Leiterplatte Lp befindlichen Dosiernadel Dn wird dann durch die Beaufschlagung der Klebstoff-Kartusche KK mit Druckluft Dl der Kleber-Tropfen Kt auf die Leiterplatte Lp gepreßt, wobei die aufdosierte Klebstoffmenge von der Dosierzeit, vom Druck der Druckluft Dl, von der Länge und dem lichten Querschnitt der Dosiernadel Dn und insbesondere auch von der Viskosität des Klebstoffes abhängt.

Um nun die Dosiergenauigkeit zu steigern, ist eine insgesamt mit KH bezeichnete Kühl- und/oder Heizeinrichtung vorgesehen, mit welcher die Temperatur des durch die Dosiernadel Dn hindurchgeführten Klebstoffes stabilisiert werden kann. Die Kühl-und/oder Heizeinrichtung KH umfaßt ein Peltier-Element PE, welches auf seiner einen Seite mit einem ersten Wärmetauscher Wt1 und auf seiner anderen Seite mit einem zweiten Wärmetauscher Wt2 verbunden und an der Halterung H der Dosiervorrichtung Dv befestigt ist. Dem ersten Wärmetauscher Wt1 wird über einen flexiblen Schlauch Sc2 als Kühl- und/oder Heizmittel Luft L mit einem Druck von beispleisweise 0,5 bar zugeführt. Die je nach den Erfordernissen vom Peltier-Element PE und dem mit Rippen versehenen zweiten Wärmetauscher Wt2 beim Durchströmen des ersten Wärmetauschers Wt1 gekühlte oder erwärmte Luft L wird dann über einen weiteren flexiblen Schlauch Sc3 und ein Röhrchen R in eine die Dosiernadel Dn bis auf deren Endbereich mit Abstand umgebende Kammer Ka eingeleitet. An dem aus Metall bestehenden Röhrchen R ist ein Temperatur-Meßfühler TM, wie z.B. ein Termoelement durch Löten befestigt. Der Temperatur-Meßfühler TM ist mit einem nicht näher dargestellten PID-Regler verbunden, welcher den Strom und die Stromrichtung des Peltier-Elements PE zur Temperaturstabilisierung des durch die Dosiernadel Dn hindurchgeführten Klebstoffes steuert.

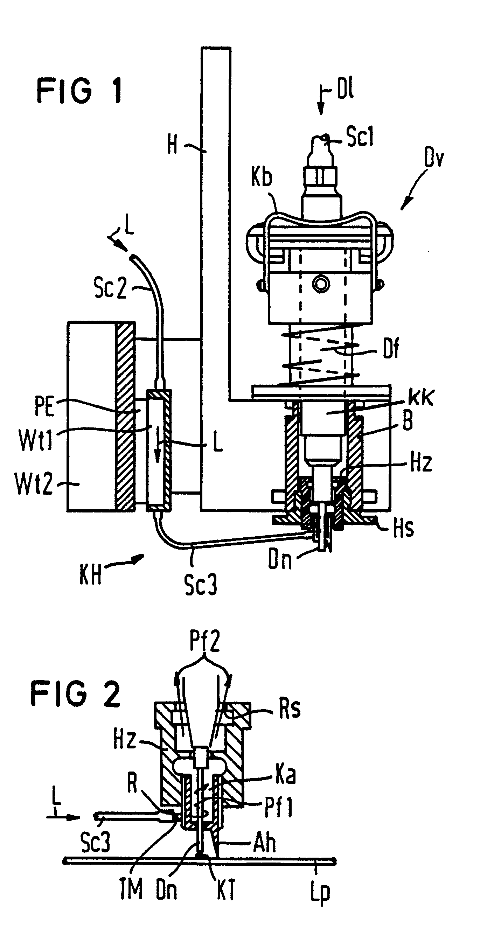

Die vorstehende erwähnte Kammer Ka wird durch den oberen hohlzylindrischen bzw. becherförmigen Teils des Abstandshalters Ah und durch einen zur besseren Wärmeisolation aus Kunststoff bestehenden Hohlzylinder Hz gebildet. Die durch das Röhrchen R in die Kammer Ka eintretende temperierte Luft L wird in der Kammer Ka verwirbelt und dann nach oben durch einen Ringspalt Rs des Hohlzylinders Hz als Abluft in den Raum abgegeben. Die zur Verbesserung des Wärmeübergangs zur Dosiernadel Dn erwünschte Verwirbelung der Luft L ist in Fig. 2 durch einen wendelförmigen Pfeil Pf1 aufgezeigt, während der Austritt der Luft L aus der Kammer Ka durch Pfeile Pf2 aufgezeigt ist. Die Befestigung des Hohlzylinders Hz in der Halterung H erfolgt über eine Buchse B und eine ringförmige Halteschraube Hs derart, daß die Klebstoff-Kartusche KK und die Dosiernadel Dn leicht ausgetauscht werden können.

Mit Hilfe der vorstehend beschriebenen Kühl- und/oder Heizeinrichtung KH kann die Temperatur des durch die Dosiernadel Dn hindurchgeführten Klebstoffes auf ein gewünschtes Temperaturniveau stabilisiert werden, so daß durch die gleichbleibende Viskosität des austretenden Klebstoffes die Dosiergenauigkeit erheblich verbessert wird. Die Stabilisierung erfolgt dabei insbesondere auf dem Niveau der Raumtemperatur, da die für die Verarbeitung erwünschte Viskosität handelsüblicher SMD-Klebstoffe in der Regel auf die Raumtemperatur abgestellt ist. In diesem Fall wird dann eine durch die Beaufschlagung mit Druckluft D1 bedingte Erwärmung des Klebstoffes durch die Kühlwirkung des Peltier-Elements PE kompensiert.

Grundsätzlich kann das Peltier-Element PE jedoch auch als Heizeinrichtung eingesetzt werden. So kann der Klebstoff beispielsweise bei einer Temperatur von 40°C bei einer niedrigeren Viskosität auf die Leiterplatte Lp aufdosiert werden, während sich dann anschließend bei Raumtemperatur durch die entsprechend erhöhte Viskosität des Klebstoffes eine sehr gute Haftung der SMD-Bausteine auf der Leiterplatte Lp ergibt.

Gegebenenfalls kann die Dosierung des Klebstoffes auch auf einem unterhalb der Raumtemperatur liegenden Temperaturniveau vorgenommen werden, wobei in diesem Fall dann das Peltier-Element PE als reine Kühleinrichtung wirkt.

## Ansprüche

1. Vorrichtung zur dosierbaren Klebstoff-Applikation auf ein Substrat, insbesondere für SMD-Bestückautomaten, bei welcher der Klebstoff unter Einwirkung von Druck einer Dosiernadel (Dn) zuführbar ist, mit einer die Dosiernadel (Dn) zumindest bereichsweise umgebenden Kammer (Ka), welcher zur Temperaturstabilisierung des durch die Dosiernadel (Dn) hindurchgeführten Klebstoffes ein Kühl- und/oder Heizmittel zuführbar ist.

2. Vorrichtung nach Anspruch 1, **dadurch gekennzeichnet**, daß oder Kammer (Ka) ein gasförmiges Kühl- und/oder Heizmittel zuführbar ist.

3. Vorrichtung nach Anspruch 1 oder 2, **dadurch gekennzeichnet**, daß in den unteren Bereich der Kammer (Ka) ein Röhrchen (R) für die Zufuhr des Kühl- und/oder Heizmittels einmündet.

4. Vorrichtung nach Anspruch 3, **dadurch gekennzeichnet**, daß an dem Röhrchen (R) ein Temperatur-Meßfühler (TM) angebracht ist.

5. Vorrichtung nach Anspruch 4, **dadurch gekennzeichnet**, daß das Röhrchen (R) aus Metall besteht.

6. Vorrichtung nach einem der Ansprüche 1 bis 5, **dadurch gekennzeichnet**, daß an der Kammer (Ka) ein nach unten ragender Abstandshalter (Ah) angebracht ist.

7. Vorrichtung nach einem der vorhergehenden Ansprüche, **dadurch gekennzeichnet**, daß zur Temperaturbeeinflussung des Kühl- und/oder Heizmittels ein Peltier-Element (PE) vorgesehen ist.

8. Vorrichtung nach Anspruch 7 und einem der Ansprüche 1 bis 6, **dadurch gekennzeichnet**, daß das Kühl- und/oder Heizmittel vor dem Eintritt in die Kammer (Ka) durch einen mit dem Peltier-Element (PE) verbundenen Wärmetauscher (Wt1) hindurchführbar ist.

9. Vorrichtung nach Anspruch 8, **dadurch gekennzeichnet**, daß dem Peltier-Element (PE) ein zweiter Wärmetauscher (Wt2) für die Abgabe oder Zufuhr von Wärme an oder aus der Umgebung zugeordnet ist.

## Claims

1. Apparatus for the dosed application of an adhesive onto a substrate, preferably for SMD automatic placement machines, in which apparatus the adhesive can be fed under the action of pressure to a dosing needle (Dn), and which has a chamber (Ka), which surrounds the dosing needle (Dn) at least partly and to which a cooling and/or heating medium can be fed for the temperature stabilization of the adhesive led through the dosing needle (Dn).

2. Apparatus according to Claim 1, characterized in that a gaseous cooling and/or heating medium can be fed to the chamber (Ka).

3. Apparatus according to Claim 1 or 2, characterized in that a tube (R) for feeding the cooling and/or heating medium discharges into the lower region of the chamber (Ka).

4. Apparatus according to Claim 3, characterized in that a temperature sensor (TM) is mounted on the tube (R).

5. Apparatus according to Claim 4, characterized in that the tube (R) consists of metal.

6. Apparatus according to one of Claims 1 to 5, characterized in that a downwardly projecting spacer (Ah) is mounted on the chamber (Ka).

7. Apparatus according to one of the preceding claims, characterized in that a Peltier element (PE) is provided for influencing the temperature of the cooling and/or heating medium.

8. Apparatus according to Claim 7 and one of Claims 1 to 6, characterized in that before entry into the chamber (Ka) the cooling and/or heating medium can be led through a heat exchanger (Wt1) connected to the Peltier element (PE).

9. Apparatus according to Claim 8, characterized in that the Peltier element (PE) is assigned a second heat exchanger (Wt2) for dissipating or supplying heat to or from the environment.


**Revendications**

1. Appareil d'application dosée d'un produit adhésif à un substrat, notamment pour des machines automatiques d'implantation du type SMD, dans lequel le produit adhésif peut être amené à une aiguille doseuse (Dn) sous l'action de la pression, comprenant une chambre (Ka) qui entoure au moins en partie l'aiguille doseuse (Dn) et à laquelle peut être envoyé, pour stabiliser la température du produit adhésif passant dans l'aiguille doseuse (Dn), un agent de refroidissement et/ou de chauffage.

2. Appareil suivant la revendication 1, caractérisé en ce qu'un agent de refroidissement et/ou de chauffage sous forme gazeuse peut être envoyé à la chambre (Ka).

3. Appareil suivant la revendication 1 ou 2, caractérisé en ce qu'un petit tube (R) pour l'amenée de l'agent refroidissement et/ou de chauffage débouche dans la partie inférieure de la chambre (Ka).

4. Dispositif suivant la revendication 3, caractérisé en ce que sur le petit tube (R) est montée une sonde de repérage de la température (TM).

5. Appareil suivant la revendication 4, caractérisé en ce que le petit tube (R) est en métal.

6. Appareil suivant l'une des revendications 1 à 5, caractérisé en ce que sur la chambre (Ka) est monté un élément de maintien à distance (Ah) faisant saillie vers le bas.

7. Appareil suivant l'une des revendications précédentes, caractérisé en ce que pour influer sur la température de l'agent de refroidissement et/ou de chauffage, il est prévu un élément Peltier (PE).

8. Appareil suivant la revendication 7 et l'une des revendications 1 à 6, caractérisé en ce que l'agent de refroidissement et/ ou de chauffage peut passer, avant d'entrer dans la chambre (Ka), dans un échangeur de chaleur (Wt1) relié à l'élément Peltier (PE).

9. Appareil suivant la revendication 8, caractérisé en ce qu'à l'élément Peltier (PE) est associé un deuxième échangeur de chaleur (Wt2), destiné à céder de la chaleur à l'extérieur ou à en recevoir.

FIG 1

FIG 2